**Europäisches Patentamt**

(19) **European Patent Office**

**Office européen des brevets**

(11) Veröffentlichungsnummer: **0 141 272**
**B1**

(12) **EUROPÄISCHE PATENTSCHRIFT**

(45) Veröffentlichungstag der Patentschrift:
04.01.89

(51) Int. Cl.⁴: **H 01 J 37/30**, H 01 J 37/20

(21) Anmeldenummer: 84111775.7

(22) Anmeldetag: 02.10.84

(54) **Einrichtung zur Ionenstrahlbearbeitung von Festkörperproben.**

(30) Priorität: 12.10.83 HU 352063

(43) Veröffentlichungstag der Anmeldung:
15.05.85 Patentblatt 85/20

(45) Bekanntmachung des Hinweises auf die Patenterteilung:
04.01.89 Patentblatt 89/1

(84) Benannte Vertragsstaaten:
AT CH DE GB LI

(56) Entgegenhaltungen:
GB-A-1 493 133
GB-A-2 010 577

(73) Patentinhaber: **Magyar Tudományos Akadémia Müszaki Fizikai Kutato Intézete, Foti ut 56., H-1047 Budapest IV. (HU)**

(72) Erfinder: **Barna, Arpád, Dipl.- Elektroing., Szinyei Merse utca 5, H-1063 Budapest (HU)**
Erfinder: **Reisinger, György, Dipl.- Ing., Sporttelep utca 45, H-1046 Budapest (HU)**
Erfinder: **Zsoldos, Lehel, Dr. Dipl.- Phys., Városmajor utca 18, H-1122 Budapest (HU)**

(74) Vertreter: **Kern, Wolfgang, Dipl.- Ing., Patentanwälte Kern, Brehm und Partner Albert-Rosshaupter- Strasse 73, D-8000 München 70 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine Einrichtung zur Ionenstrahlbearbeitung von Festkörperproben gemäß dem Oberbegriff des Anspruchs 1.

Eine solche Einrichtung, die insbesondere zur Bearbeitung von Materialproben derart dient, daß Oberflächenschichten von diesen Proben entfernt werden, ist mit einer Ionenquelle versehen, welche zur Erzeugung von Ionenstrahlen kleinen Durchmessers (< 1 mm) und großer Stromdichte geeignet ist.

Die Ionenstrahlzerstäubung bei der Herstellung von Proben für die Transmissionselektronenmikroskopie wird seit etwa 1960 angewandt (H.Ducher und W.Schlette, "Über die Herstellung von durchstrahlbaren Metallfolien durch Ionenätzung", Coll. Ing. du C.N.R.S. Nr.1113,83-90 Bellevue (1962)). Über die Verfahren und die Verdünnungseinrichtungen geben die im folgenden zusammengefaßten Literaturangaben einen guten überblick.

H.Bach, "Die Anwendbarkeit des Ionenstrahlätzens bei der Präparation für die Elektronenmikroskopie"; G.Schimmel, W.Vogell, "Methodensammlung der Elektronenmikroskopie", Wissenschaftl. Verlag MBH, Stuttgart 1970, 2.4.2.1.; J. Francks, "Ion Beam Technology Applied to Electron Microscopy", (Advances in Electronics and Electron Physics, Vol 47, Ed.L.Marton; Acad.Press, New York 1978, Seiten 1 bis 48).

Das gemeinsame Kennzeichen der bekannten Einrichtungen besteht darin, daß an beiden Seiten der zu verdünnenden Materialprobe zwei einander gegenübergestellte, miteinander fest verbundene Ionenquellen verwendet werden, die mit den ebenfalls fest angeordneten, sich in seiner Ebene drehenden Probenhalter um eine Tangente gemeinsam drehbar sind. So ergibt sich die Möglichkeit dafür, daß die Probe gleichzeitig auf beiden Seiten entweder mit der optimalen Zerstäubungsgeschwindigkeit (in einem Winkel von ca. 70°) oder mit dem optimalen Polierwinkel (ca. 85°) verdünnt wird. Der Verdünnungsprozeß wird mit einem außerhalb des Zerstäubungsraumes angebrachten optischen Mikroskop beobachtet. Häufig werden Laser oder andere automatische Prozeßunterbrecher angewendet. Die Einrichtungen benutzen als Ionenquellen entweder Hohlraumanodenquellen (z. B. C. G. Crocket, "A glow discharge ion gun for etching", Vacuum 23, 11-13, 1973) oder mit einem magnetischen Feld kombinierte Spiegelkathodenquellen (z. B. D.J Barber, "Thin Foils of Non-Metalls Made for Electron Microscopy by Sputter-Etching", J. of Materials Sci. 5,1-8, 1970), oder enthalten elektrostatische Sattelfeld-Quellen,(z. B. J.Franks, "A saddle field ion source of spherical configuration for etching and thinning applications", Vacuum 24, 489-491, 1974). Wegen des relativ großen Ionenstrahldurchmessers (> 1 mm) ist die mit den bekannten Einrichtungen erreichbare Zerstäubungsgeschwindigkeit gering. Sie beträgt beispielsweise bei Si 10 μm/Stunde.

Infolge der in bezug aufeinander fest angeordneten Ionquellen und feststehenden Probenhalters ergeben sich weitere nachteilige Folgen, nämlich:

a) Wegen des feststehenden Probenhalters kann mit dem Beobachtungsmikroskop der Verlauf des Zerstäubens auf der Rückseite nicht kontrolliert werden.

b) Wegen der Fixierung der Ionenquellen in bezug aufeinander und in bezug auf ihre gemeinsame Drehebene mit dem Probenhalter ergeben sich folgende Schwierigkeiten:

- Die während des Betriebs der Quellen auftretenden Aufladungen lenken die austretenden Ionenstrahlen von der mechanischen Zentrierachse ab, so daß der Ionenstrahl nicht an der gewünschten Stelle die Probe angreift. Dies wird durch den relativ großen Ionenstrahldurchmesser kompensiert, wobei jedoch diese Lösung insofern nachteilig ist, als sie den in der Probe verursachten Strahlungsschaden sowie die Wärmebelastung der Probe vergrößert.

- Häufig darf in der Halbleitertechnik bei Untersuchungen von dünnen Schichten o.dgl. die Probe nur auf der einen Seite verdünnt werden. Wegen der festen Quellenanordnung muß in diesen Fällen die eine Ionenquelle ausgeschaltet werden, was eine Verlängerung der Verdünnungszeit zur Folge hat.

Die Aufgabe der Erfindung besteht darin, die oben genannten Nachteile zu beseitigen und eine Einrichtung zur Ionenstrahlbearbeitung zu schaffen, die bezüglich ihrer Poliereigenschaften vorteilhafter ist als die bekannten.

Diese Aufgabe wird erfindungsgemäß dadurch gelöst, daß die Ionenquellen voneinander unabhängig um weitere Drehachsen drehbar und an diesen entlang verschiebbar gelagert sind, und daß diese weiteren Drehachsen parallel zu der zentralen Drehachse angeordnet sind.

Mit Hilfe der Erfindung kann die optimale Betriebsgeometrie sicher und leicht eingestellt bzw. während des Betriebs korrigiert werden.

Unter diesen Umständen ist es vorteilhaft, bei der Verdünnung mittels Ionenstrahlen den Durchmesser des Ionenstrahls < 0,1 mm zu wählen, so daß z. B. im Falle eines bei 87° liegenden, fast streifenden Strahleinfall, nicht das zu verdünnende Gebiet überhängt. Andererseits kann gleichzeitig im Interesse einer schnelleren Verdünnung die Stromdichte bis zu 20 mA/cm² gesteigert werden, ohne daß eine wesentliche Erwärmung der Probe und des Probenhalters eintritt.

Die Erfindung wird im folgenden anhand von in der Zeichnung dargestellten Beispiele näher erläutert. In der Zeichnung zeigen:

Fig. 1 eine kinematische und schematische Darstellung der erfindungsgemäßen Einrichtung,

Fig. 2 eine Aufrißansicht der Dreheinführung der Einrichtung von Fig. 1,

Fig. 3 eine Längsschnittansicht längs der Linie A-A in Fig. 2,

Fig. 4 eine Teilaufrißansicht des Probenhalters der Einrichtung von Fig. 1,

Fig. 5 eine Querschnittsansicht längs der Linie B-B in Fig. 4,

Fig. 6 eine Längsschnittansicht einer verwendbaren Ionenquelle.

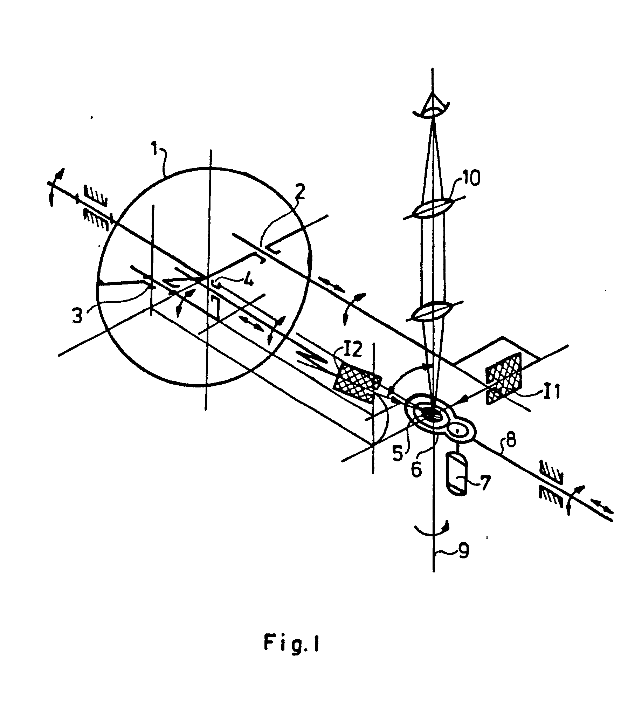

Aus der kinematischen Darstellung von Fig. 1 sind die im Vakuumraum angebrachten, unabhängigen Ionenquellen I1 und I2 ersichtlich, die von der Dreheinführung 1 mittels der auf ihr angebrachten Drehachsen 2, 3 und 4 gehalten werden. Den zur Aufnahme der zu bearbeitenden Materialprobe 5 dienenden Probenhalter 6 dreht ein ebenfalls im Vakuumraum untergebrachter Motor 7 um eine zur Achse der Dreheinführung 1 senkrechte Achse, wobei das Ganze auch um die mit der Dreheinführung 1 zusammenfallende Drehachse 8 drehbar ist. Unterhalb des Probenhalters ist eine kleine Lichtquelle 9 angeordnet und oberhalb desselben ein Mikroskop 10, mit dem die Wirkung des Ionenbeschusses auch während des Betriebs beobachtet werden kann.

Die Lage des Angriffspunktes der auf die Materialprobe auftreffenden Ionenstrahlen kann dadurch geändert werden, daß die Ionenquellen I1 und I2 etwas um die Drehachsen 2 und 4 gedreht und längs dieser Achsen etwas verschoben werden. Zur Änderung des Beugungswinkels der Ionenquellen I1 und I2 wird die Ionenquelle I2 um die Drehachsen 3 und 4 in entgegengesetzter Richtung gedreht. Schließlich kann die Änderung des Einfallswinkels der Ionenstrahlen sowohl durch Drehen der Dreheinführung 1 als auch durch Drehen des Probenhalters 6 um die Drehachse 8 vorgenommen werden.

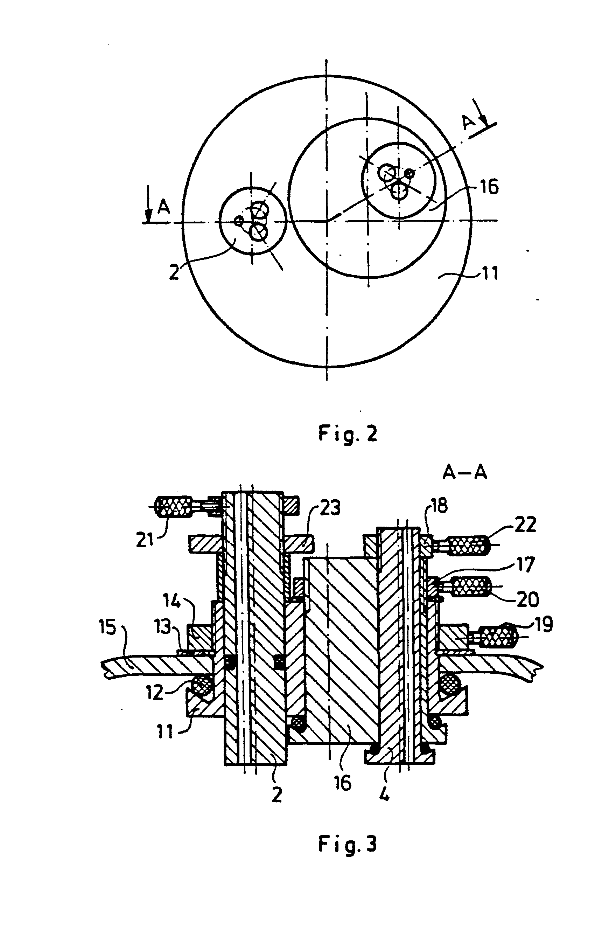

Eine mögliche Ausführungsform der Dreheinführung 1 zeigen die Figuren 2 und 3. Der Körper 11 der Dreheinführung 1 ist unter Zwischenschaltung des die Vakuumdichtung sichernden O-Rings 12 und der Teflon-Unterlage 13 mit Hilfe des Gewinderinges 14 an der Wand der Vakuumkammer 15 drehbar befestigt. Der Körper 11 weist zwei exzentrische Bohrungen auf, wobei in der größeren dieser Bohrungen eine drehbare Einlage 16 angeordnet ist, in der, ebenfalls exzentrisch, sich eine weitere Bohrung befindet. Diese Einlage bildet die Drehachse 3. In den beiden genannten exzentrischen, kleineren Bohrungen sind die Drehachsen 2 und 4 der Ionenquellen gelagert, die je 3 Bohrungen enthalten, welche zum Einleiten des Kühlwassers und des in die Ionenquellen einzubringenden Gases dienen. Die Gewinderinge 17 bzw. 18 an der Einlage 16 bzw. an dem Ende der Achse 4 dienen genauso wie der Gewindering 14 zum Einstellen des auf die Dichtungsringe wirkenden Druckes. Der Körper 11 bzw. die Einlage 16 und die Drehachsen 2 und 4 sind mit Hilfe der Arme 19 bzw. 20 und 21, 22 von außen frei drehbar.

Am Ende der Drehachse 2 befindet sich ein weiterer Gewindering 23, der sich auf dem Körper mittelbar abstützt. Durch Drehen desselben läßt sich die Drehachse 2 parallel zu sich selbst verschieben. Das Verschieben der Drehachse 4 macht den im folgenden erläuterten, verschiebbaren Probenhalter überflüssig.

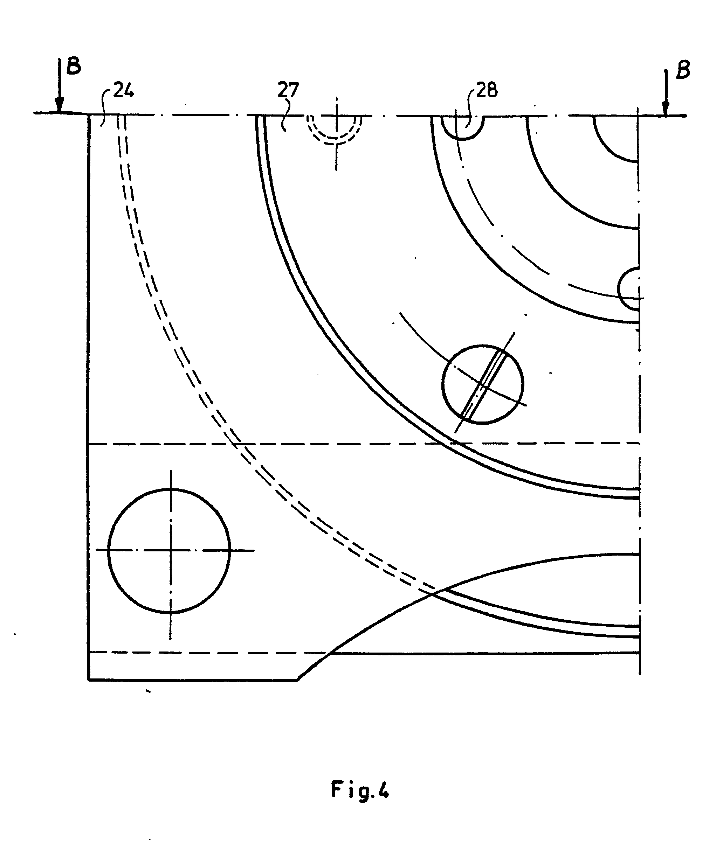

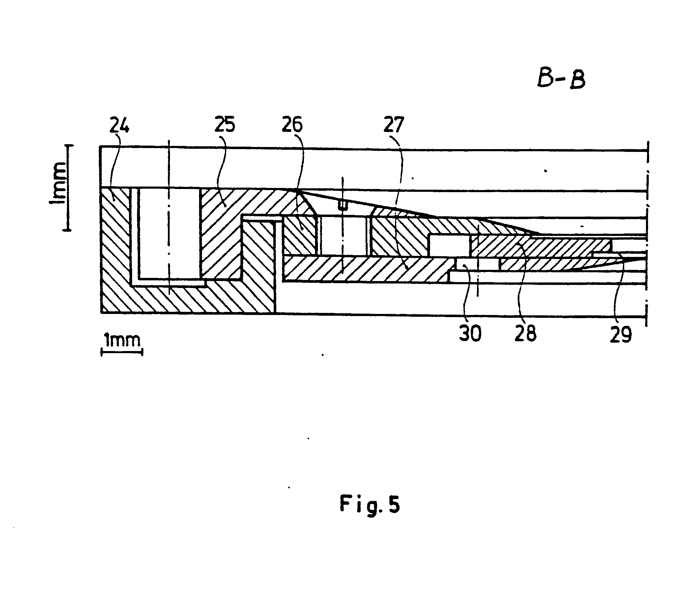

Eine mögliche Ausführungsform des zur Probenaufnahme dienenden Probenhalters 6 zeigen die Figuren 4 und 5. Der Motor 7 treibt den sich im Sitz 24 drehenden, verzahnten Ring 25 an. Zwischen den an ihm befestigten Halteplatten 26 und 27 liegt die Einlageplatte 28 mit der zur Aufnahme der zu verdünnenden Materialprobe 5 geeigneten Vertiefung 29. Die Halteplatte 26 ist so ausgebildet, daß die Einlageplatte 28 mittels der in der Halteplatte 27 befindlichen vier Bohrungen 30 in jeder Richtung verschoben werden kann, so daß unter dem Mikroskop jeder Punkt der zu verdünnenden Materialprobe 5 in den Drehungsmittelpunkt gerückt werden kann.

Der in der oben beschriebenen Weise ausgebildete fläche Probenhalter, der etwa 1,5 mm dick ist, ermöglicht beispielsweise einen Ionenbeschuß unter einem Neigungswinkel von 87° zur Normalen, und zwar von beiden Seiten.

Es ist vorteilhaft, wenn das Material der Halteplatten 26, 27 und der Einlageplatte 28 des Probenhalters 6 Titan ist, da dieses Material unter der Einwirkung des Ionenstrahls nur geringfügig zerstäubt wird und seine weitere vorteilhafte Eigenschaft darin besteht, daß die Einschlagstelle der Ionen sichtbar wird, da das Titan bei der Einwirkung von Ar-Ionenstrahlen sichtbares Licht emittiert.

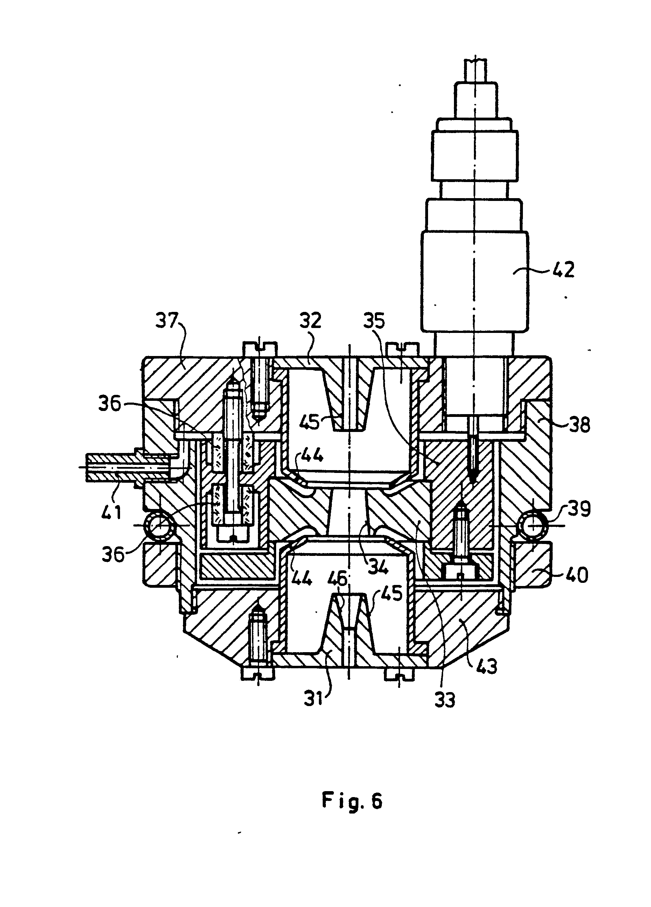

Einen Längsschnitt einer der möglichen anwendbaren Ionenquellen zeigt Fig. 6. Die gemeinsame Anode 33 liegt zwischen den beiden sich einander gegenüberstehenden Kathodenteilen 31 und 32 des auf Erdpotential liegenden, drehsymmetrischen, fokussierenden Elektrodensystems und besitzt zur Verstärkung des Ionenstroms an der Probenseite eine assymmetrische, konische Anodenbohrung 34.

Die schnell zerstäubenden Teile des Kathodensystems sind austauschbar, ohne daß die Ionenquelle hierfür vollständig auseinandergenommen werden muß. In ähnlicher Weise sind die mittleren Teile der Anode austauschbar, deren Haltering 35 über zwischengeschaltete Porzellanisolatoren 36 an der Grundplatte 37 des Gehäuses befestigt ist. Zum leichteren Instandhalten ist das Gehäuse aus drei Teilen aufgebaut. Von ihnen ist der mittlere Teil 38 mit dem Gewindering 40 an dem die ganze Ionenquelle haltendem Kühlwasserrohr 39 befestigt, und daran schließt sich auch die Gaseinführung 41 an. Die Grundplatte 37, die auch den Hochspannungsanschluß 42 trägt, kann zusammen mit der Anodenarmatur abgeschraubt werden. In ähnlicher Weise ist auf der Austrittsseite der den Kathodenteil 31 tragende Deckel 43 abschraubbar.

Wie durchgeführte Experimente zeigen, bildet sich in der so hergestellten Ionenquelle ein ionisierter Kanal mit kleinem Durchmesser und großer Stromdichte, woraus folgt, daß der austretende Ionenstrahl ebenfalls einen kleinen Durchmesser aufweist, sich kaum ausbreitet, d.h., kaum streut, und die notwendige Stromdichte leicht sichergestellt werden kann, um beispielsweise eine Geschwindigkeit von etwa 50 μm/Stunde bei Si. Auch läßt sich mit Ablenkungselektroden, die hinter der Austrittsöffnung 46 angebracht und in den Zeichnungsfiguren nicht dargestellt sind, eine Raster-Ionenquelle verwirklichen. Der wahre, verdünnende Ionenstrom kann auf dem isolierten Probenhalter oder der von ihm abhängige Ionenstromwert kann mit Hilfe einer Auffangelektrode, die entweder auf der einen oder anderen Seite des Probenhalters angeordnet ist, gemessen werden.

Die erfindungsgemäße Einrichtung zur Ionenstrahlenbearbeitung weist die im folgenden angeführten Vorteile auf:

a) Die Ionenquellen I1 und I2 sind in bezug auf die Materialprobe und in bezug aufeinander verschwenkbar und voneinander unabhängig zentrierbar, wodurch ermöglicht wird, daß sich die beiden gegenüberliegenden Ionenquellen bei gleichzeitigem Betrieb die Materialprobe sowohl von der Vorderseite als auch von der Rückseite verdünnen. Ferner wird dadurch erreicht, daß die Materialprobe bei entsprechender Anwendung des aus den Ionenquellen austretenden schmalen Ionenstrahls und großer Stromdichte beim Beschuß unter einem kleinen Winkel, bezogen auf ihre Berührungsebene, nur an der entsprechenden Stelle vom Ionenstrahl getroffen wird, so daß bei hoher Zerstäubungsgeschwindigkeit die Strahlenbelastung der Materialprobe gering bleibt. Des weiteren wird dadurch erreicht, daß mit den beiden einander gegenüberstehenden Ionenkanonen bei einer von einer Seite verdünnten Materialprobe durch Verschiebung des Drehmittelpunktes des Probenhalters in bezug auf den Angriffspunkt der Ionenstrahlen ein Ringbereich auf der Materialprobe geätzt wird (im Falle einer Quelle ergibt sich eine Oberflächenstruktur, die Transmissionselektronenmikroskopuntersuchungen stört).

b) Der Probenhalter kann senkrecht zur Ionenkanone verschoben werden und ist auf seiner Achse drehbar, und innerhalb des Probenhalters läßt sich der Drehmittelpunkt der zu verdünnenden Materialprobe einstellen. Dies ermöglicht eine Kontrolle der Zerstäubung an der Probenrückseite mit einem optischen Mikroskop sowie zusammen mit der oben genannten Ätzmöglichkeit des Ringbereiches bzw. unter Berücksichtigung der Intensitätsverteilung des Ionenstrahls die Ausbildung eines Untersuchungsbereiches für die Transmissionselektronenmikroskopie mit einem relativ großen Durchmesser von ≦ 0,5 mm. Des weiteren ist dadurch die Möglichkeit gegeben, ein nicht unbedingt in der Mitte der Materialprobe liegendes, ausgewähltes Gebiet zu verdünnen (Zielpräparierung).

c) Der durch die Einwirkung des Ionenstrahls leuchtende Probenhalter ermöglicht die genaue Einstellung der Ionenkanonen bzw. der Lage des Probenhalters sowie eine schnelle Korrektur der während des Betriebs durch Ladungseinwirkung verursachten Ionenstrahlverschiebungen.

## Patentansprüche

1. Einrichtung zur Ionenstrahlbearbeitung, insbesondere zur Verdünnung von Festkörperproben, mit einem die zu bearbeitenden Proben tragenden Probenhalter und wenigstens zwei Ionenquellen im Vakuumraum der Einrichtung, wobei der Probenhalter und die Ionenquellen in bezug aufeinander um eine zentrale Achse drehbar gelagert sind, dadurch gekennzeichnet, daß die Ionenquellen (I1, I2) voneinander unabhängig um weitere Drehachsen (2, 4) drehbar und an diesen entlang verschiebbar gelagert sind, und daß diese weiteren Drehachsen (2, 4) parallel zu der zentralen Drehachse angeordnet sind.

2. Einrichtung nach Anspruch 1, dadurch gekennzeichnet, daß die Drehachsen (2, 4) der Ionenquellen (I1, I2) in einer gemeinsamen Dreheinführung (1) in der den Vakuumraum begrenzenden Wand angeordnet sind.

3. Einrichtung nach Anspruch 1 oder 2, dadurch gekennzeichnet, daß der Probenhalter (6) um eine mit der Achse der Dreheinführung (1) zusammenfallende Drehachse (8) drehbar und an ihr entlang verschiebbar gelagert ist.

4. Einrichtung nach einem der Ansprüche 1 bis 3, dadurch gekennzeichnet, daß der Probenhalter (6) eine in einer eigenen Ebene drehbare Struktur besitzt die so ausgebildet ist, daß der Drehmittelpunkt der Probe (5) variierbar ist.

5. Einrichtung nach einem der Ansprüche 1 bis 4, dadurch gekennzeichnet, daß der die Probe direkt umgebende Teil des Probenhalters (6) aus Titan besteht.

6. Einrichtung nach einem der Ansprüche 1 bis 5, dadurch gekennzeichnet, daß die Ionenquellen (I1, I2) mit einer den austretenden Ionenstrahl ablenkenden, steuerbaren Einrichtung versehen sind.

## Claims

1. Apparatus for processing using ion beams, especially for thinning solid state sample, comprising a sample holder supporting the samples which are to be processed and further comprising at least two ion sources within the vacuum space of the apparatus, wherein the sample holder and the ion sources are with respect to one another mounted pivotally on a central axis, <u>characterized</u> in that the ion sources (I1, I2) are independently from one another rotatable about further pivot axes (2, 4) and are slidably mounted along the said axes and that said further pivot axes (2, 4) are arranged parallel to the central pivot axis.

2. Apparatus according to claim 1, <u>characterized</u> in that the pivot axes (2, 4) of the ion sources (I1, I2) are positioned within a common rotating insert (1) within the wall limiting the vacuum space.

3. Apparatus according to claim 1 or 2, <u>characterizing</u> in that the sample holder (6) is rotatable mounted about a rotating axis (8) coinciding with the axis of the rotating insert (1) and is slidably mounted along said axis.

4. Apparatus according to one of the claims 1 through 3, <u>characterizing</u> in that the sample holder (6) forms a construction which is rotatable within an own level and which is structured thus that the central point of rotation of the sample (5) is variable.

5. Apparatus according to one of the claims 1 through 4, <u>characterized</u> in that that part of the sample holder (6) which is directly surrounding the sample, consists of titanium.

6. Apparatus according to one of the claims 1 through 5, <u>characterized</u> in that the ion sources (I1, I2) are provided with a controllable means for deflecting the emerging ion beam.

## Revendications

1. Dispositif pour le traitement de rayons ioniques, en particulier pour la dilution d'échantillons solides, comportant un porte-échantillons portant les échantillons à traiter et au moins deux sources ioniques dans la chambre à vide du dispositif, le porte-échantillons et les sources ioniques étant logés l'un par rapport aux autres tournant autour d'un axe central, <u>caractérisé</u> par le fait que les sources ioniques (I1, I2) sont logées indépendamment l'une de l'autre tournant autour d'autres axes de rotation (2, 4) et amovibles le long de ces derniers, et que ces autres axes de rotation (2, 4) sont disposés parallèlement à l'axe de rotation central.

2. Dispositif d'après la revendication 1, <u>caractérisé</u> par le fait que les axes de rotation (2, 4) des sources ioniques (I1, I2) sont disposés dans un insert de rotation commun (1) dans la paroi limitant la chambre à vide.

3. Dispositif d'après la revendication 1 ou 2, <u>caractérisé</u> par le fait que le porte-échantillons (6) est logé tournant autour et amovible le long d'un axe de rotation (8) coïncidant avec l'axe de l'insert de rotation (1).

4. Dispositif d'après l'une des revendications 1 à 3, <u>caractérisé</u> par le fait que le porte-échantillons (6) possède une structure tournant dans son propre plan de rotation et qui est constituée de façon que le centre de rotation de l'échantillon (5) est variable.

5. Dispositif d'après l'une des revendications 1 à 4, <u>caractérisé</u> par le fait que la partie directement entourant l'échantillon du porte-échantillon (6) consiste en titane.

6. Dispositif d'après l'une des revendications 1 à 5, <u>caractérisé</u> par le fait que les sources ioniques (I1, I2) sont munies d'un dispositif pouvant être commandé et qui dévie le rayon ionique sortant.

Fig.1

Fig. 2

Fig. 3

Fig.4

B-B

Fig. 5

Fig. 6